# EUROPEAN PATENT APPLICATION

(11) **EP 4 242 270 A1**
(43) Date of publication of application: **13.09.2023**
(21) Application number: 21889231.3
(22) Date of filing: 04.11.2021
(51) Int. Cl.: C09D 5/00, C09D 123/28, C09D 127/10, C09D 7/61, H05K 1/03

(54) **AQUEOUS COATING COMPOSITION, AND COATED ARTICLE**

(30) Priority: 06.11.2020 JP 2020185952
(71) Applicant: Daikin Industries, Ltd., Osaka-shi, Osaka 530-0001 (JP)
(72) Inventor: UEDA, Yuki, Osaka-shi, Osaka 530-8323 (JP); OKUNO, Shingo, Osaka-shi, Osaka 530-8323 (JP); KOMORI, Hirokazu, Osaka-shi, Osaka 530-8323 (JP); NAKATANI, Yasukazu, Osaka-shi, Osaka 530-8323 (JP); YAMAUCHI, Akiyoshi, Osaka-shi, Osaka 530-8323 (JP)
(74) Representative: Goddar, Heinz J.
(86) International application number: PCT/JP2021/040584
(87) International publication number: WO 2022/097678

(57) **Abstract**

Provided is an aqueous coating material composition having a low linear expansion coefficient, capable of suppressing warpage of the substrate by applying to a metal substrate such as a copper foil. An aqueous coating material composition comprising fluororesin particles (A) that can be melt-molded, further comprising silica particles (B), a non-fluorinated surfactant (C) and water (D), wherein the fluororesin particles (A) have an average particle size of 0.05 to 1000 µm, wherein the silica particles (B) have an average particle size of 0.1 to 20 µm,wherein the fluororesin particles (A) and the silica particles (B) have a blending ratio: Fluororesin particles (A)/Silica particles (B) = 10/90 to 90/10 (mass ratio), and wherein a content of fluororesin particles (A) is 15 to 80 mass% relative to 100 mass% of solid content of the coating material.

## Description

### Technical Field

The present invention relates to an aqueous coating material composition and a coated article.

### Background Art

A fluororesin is known to have various applications and various usage forms such as powder and film based on the excellent heat resistance, weather resistance, oil resistance, solvent resistance, chemical resistance and non-stickiness thereof.

In a printed wiring board for use in a high frequency region of several tens of gigahertz level also, a laminate having an insulating layer of fluororesin is mainly used from the viewpoints of dielectric properties and hygroscopicity.

In Patent Literature 1, an aqueous coating material composition for forming a coating layer made of fluororesin on a metal substrate is disclosed.

In Patent Literature 2, a coating material composition for forming a coating layer made of fluororesin on a metal substrate is disclosed, and the coating material composition blended with silica is also disclosed.

In Patent Literature 3 to 5, an aqueous coating material composition containing fluororesin particles is disclosed.

### Citation List

### Patent Literature

Patent Literature 1 International Publication No. WO 1994/05729
Patent Literature 2 Japanese Patent Laid-Open No. 2009-1767
Patent Literature 3 Japanese Patent Laid-Open No. 5-301974
Patent Literature 4 International Publication No. WO 2020/071382
Patent Literature 5 International Publication No. WO 2018/016644

### Summary of Invention

### Technical Problem

An object of the present disclosure is to provide an aqueous coating material composition to be applied to a metal substrate such as a copper foil, capable of suppressing warpage of the substrate.

### Solution to Problem

The present disclosure relates to an aqueous coating material composition containing fluororesin particles (A) that can be melt-molded,
further containing silica particles (B), a non-fluorinated surfactant (C) and water (D),
wherein the fluororesin particles (A) have an average particle size of 0.05 to 1000 µm,
wherein the silica particles (B) have an average particle size of 0.1 to 20 µm,
wherein the fluororesin particles (A) and the silica particles (B) have a blending ratio: Fluororesin particles (A)/Silica particles (B) = 10/90 to 90/10 (mass ratio), and
wherein a content of fluororesin particles (A) is 15 to 80 mass% relative to 100 mass% of solid content of the coating material.

It is preferable that the aqueous coating material composition further contains a glycol solvent (E).

It is preferable that none of the glycol solvent (E) remain after sintering of the fluororesin particles (A).

It is preferable that the silica particles (B) have a maximum particle size of 10 µm or less.

It is preferable that the silica particles (B) have a water dispersibility of 30 mass% or more.

It is preferable that the fluororesin particles (A) have an average particle size of 0.1 to 100.

It is preferable that the fluororesin particles (A) have a particle size at a cumulative volume of 50% of 0.05 to 40 µm.

It is preferable that the non-fluorinated surfactant (C) is a silicone surfactant.

The present disclosure also relates to a coated article characterized by having a coating layer formed by application of the aqueous coating material composition.

The coated article may be a coated article having a coating layer formed by application of the aqueous coating material composition on a metal substrate.

The coated article may be a printed circuit board, a dielectric material for a circuit board, or a laminated circuit board.

### Advantageous Effects of Invention

According to the present disclosure, an aqueous coating material composition excellent in electrical properties and surface physical properties, and capable of forming a fluororesin coating layer with suppression of warpage can be obtained, without use of a fluorinated surfactant.

### Description of Embodiment

In fabrication of a fluororesin circuit board by laminating a fluororesin and a metal conductor, warpage occurs in reflow processing at a temperature of about 260°C. The fluororesin circuit board with having such warpage cannot be used as a high-frequency circuit board.

Silica is excellent in corrosion resistance to fluorine even at a reflow temperature of 260°C or more, and has a smaller thermal expansion coefficient than a fluororesin. By forming a fluororesin coating layer blended with the silica, the difference between the thermal expansion coefficient of the coating layer and the thermal expansion coefficient of the metal substrate is decreased, so that the occurrence of warpage during reflow can be suppressed. Further, use of the aqueous coating material composition of the present disclosure in combination with a non-fluorinated surfactant suppresses decomposition caused by hydrofluoric acid generated during reflow is suppressed, so that the effect of blending silica can be efficiently obtained.

The specific surface area of the silica particles (B) measured by the BET method is, for example, preferably 1.0 to 25.0 m²/g, more preferably 1.0 to 10.0 m²/g, and still more preferably 2.0 to 6.4 m²/g. With a specific surface area in the range, the coating film surface is smooth due to less aggregation of silica in a film, which is preferable.

The silica particles (B) have an average particle size of 0.1 to 20 µm. With an average particle size in the range, favorable surface roughness can be obtained due to less aggregation. The lower limit of the average particle size is preferably 0.1 µm, more preferably 0.3 µm. The upper limit of the average particle size is preferably 5 µm, more preferably 2 µm. The average particle size is a value measured by a laser diffraction/scattering method.

It is preferable that the silica particles (B) have a maximum particle size of 10 µm or less. With a maximum particle size of 10 µm or less, the dispersion state is favorable due to less aggregation. Further, the surface roughness of the resulting coating film can be reduced. The maximum particle size is more preferably 5 µm or less. The maximum particle size was determined from the image data of 200 randomly selected particles, based on an SEM (scanning electron microscope) photograph with use of an image analysis software for SEM.

The shape of the silica particles (B) is not limited, and a spherical shape, a columnar shape, a spindle shape, a frustum shape, a polyhedral shape, a hollow shape or the like may be employed. In particular, a spherical shape, a cubic shape, a bowl shape, a disc shape, an octahedral shape, a flaky shape, a stick shape, a plate shape, a rod shape, a tetrapod shape, or a hollow shape is preferred, and a spherical shape, a cubic shape, an octahedral shape, a plate shape or a hollow shape is more preferred.

It is preferable that the silica particles (B) have a water dispersibility of 30 mass% or more. With a water dispersibility of less than 30 mass%, the stability of the aqueous coating material composition may be lowered due to insufficient dispersibility.

Regarding the water dispersibility, after silica and water are weighed in a container and dispersed with sufficient shearing force, it is checked that the silica surface gets wet and no sedimentation occurs for several minutes when stirring is stopped.

The silica particles (B) may be surface-treated, for example, with a silicone compound. By surface-treating with the silicone compound, the dielectric constant of the silica particles (B) can be reduced.

The silicone compound is not limited, and a conventionally known silicone compound may be used. For example, it is preferable that the silicone compound comprise at least one selected from the group consisting of silane coupling agents and organosilazanes.

Regarding the surface treatment amount of the silicone compound, the reaction amount of a surface-treating agent on the surface of the silica particles is preferably 0.1 to 10 pieces, more preferably 0.3 to 7 pieces, per unit surface area (nm²).

As the silica particles (B), one type or two or more types having different physical properties may be used.

Further, as the silica particles (B), powder may be used as it is, or powder dispersed in a resin may be used.

The aqueous coating material composition of the present disclosure is blended with fluororesin particles (A) that can be melt-molded. It is preferable to use such fluororesin particles (A) from the viewpoint of improving processability with improved uniformity of the coating film and film strength after molding.

The compositional features of the fluororesin particles (A) that can be melt-molded is not limited, and examples thereof include a tetrafluoroethylene [TFE]/hexafluoropropylene [HFP] copolymer [FEP], a TFE/fluoroalkyl vinyl ether copolymer [PFA], a TFE/HFP/fluoroalkyl vinyl ether copolymer [EPA], a TFE/chlorotrifluoroethylene [CTFE] copolymer, a TFE/ethylene copolymer [ETFE], polyvinylidene fluoride [PVdF], and tetrafluoroethylene [LMW-PTFE] having a molecular weight of 300,000 or less. One type may be used, or two or more types may be mixed.

It is preferable that the fluoroalkyl vinyl ether be at least one selected from the group consisting of, for example,
a fluoromonomer represented by a general formula (110): CF₂=CF-ORf¹¹¹
wherein Rf¹¹¹ represents a perfluoro organic group;
a fluoromonomer represented by a general formula (120): CF₂=CF-OCH₂-Rf¹²¹
wherein Rf¹²¹ is a perfluoroalkyl group having 1 to 5 carbon atoms;
a fluoromonomer represented by a general formula (130): CF₂=CFOCF₂ORf¹³¹
wherein Rf¹³¹ is a linear or branched perfluoroalkyl group having 1 to 6 carbon atoms, a cyclic perfluoroalkyl group having 5 to 6 carbon atoms, or a linear or branched perfluorooxyalkyl group having 2 to 6 carbon atoms containing 1 to 3 oxygen atoms;
a fluoromonomer represented by a general formula (140): CF₂=CFO(CF₂CF(Y¹⁴¹)O)ₘ(CF₂)ₙF
wherein Y¹⁴¹ represents a fluorine atom or a trifluoromethyl group, m is an integer of 1 to 4, and n is an integer of 1 to 4; and
a fluoromonomer represented by a general formula (150): CF₂=CF-O-(CF₂CFY¹⁵¹-O)ₙ-(CFY¹⁵²)ₘ-A¹⁵¹
wherein Y¹⁵¹ represents a fluorine atom, a chlorine atom, a -SO₂F group or a perfluoroalkyl group, the perfluoroalkyl group may contain an ethereal oxygen and a -SO₂F group, n represents an integer of 0 to 3, n Y¹⁵¹ may be the same or different, Y¹⁵² represents a fluorine atom, a chlorine atom or an -SO₂F group, m represents an integer of 1 to 5, m Y¹⁵² may be the same or different, A¹⁵¹ represents -SO₂X¹⁵¹, -COZ¹⁵¹ or -POZ¹⁵²Z¹⁵³, X¹⁵¹ represents F, Cl, Br, I, -OR¹⁵¹ or -NR¹⁵²R¹⁵³, Z¹⁵¹, Z¹⁵² and Z¹⁵³ are the same or different and represent -NR¹⁵⁴R¹⁵⁵ or - OR¹⁵⁶, R¹⁵¹, R¹⁵², R¹⁵³, R¹⁵⁴, R¹⁵⁵ and R¹⁵⁶ are the same or different and represent an alkyl group, an aryl group, or a sulfonyl-containing group that may contain H, ammonium, an alkali metal, or a fluorine atom.

In the present specification, the "perfluoro organic group" means an organic group in which all hydrogen atoms bonded to carbon atoms are replaced with fluorine atoms. The perfluoro organic group may have an ether oxygen.

Examples of the fluoromonomer represented by the general formula (110) include a fluoromonomer in which Rf¹¹¹ is a perfluoroalkyl group having 1 to 10 carbon atoms. The perfluoroalkyl group has preferably 1 to 5 carbon atoms.

Examples of the perfluoro organic group in the general formula (110) include a perfluoromethyl group, a perfluoroethyl group, a perfluoropropyl group, a perfluorobutyl group, a perfluoropentyl group, and a perfluorohexyl group.

Further, examples of the fluoromonomer represented by the general formula (110) include the following. In the general formula (110), one in which Rf¹¹¹ is a perfluoro(alkoxyalkyl) group having 4 to 9 carbon atoms, one in which Rf¹¹¹ is a group represented by the following formula: 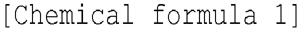 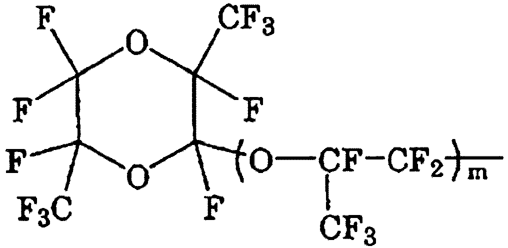 wherein m represents 0 or an integer of 1 to 4, and one in which Rf¹¹¹ is a group represented by the following formula: 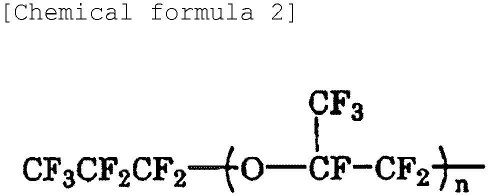 wherein n represents an integer of 1 to 4.

Among the fluoromonomers represented by the general formula (110), a fluoromonomer represented by a general formula (160):
CF₂=CF-ORf¹⁶¹
wherein Rf¹⁶¹ represents a perfluoroalkyl group having 1 to 10 carbon atoms, is preferred. It is preferable that Rf¹⁶¹ be a perfluoroalkyl group having 1 to 5 carbon atoms.

It is preferable that the fluoroalkyl vinyl ether be at least one selected from the group consisting of fluoromonomers represented by the general formulas (160), (130) and (140).

The fluoromonomer represented by the general formula (160) is preferably at least one selected from the group consisting of perfluoro(methyl vinyl ether), perfluoro(ethyl vinyl ether), and perfluoro(propyl vinyl ether), and more preferably at least one selected from the group consisting of perfluoro(methyl vinyl ether) and perfluoro(propyl vinyl ether).

It is preferable that the fluoromonomer represented by the general formula (130) be at least one selected from the group consisting of CF₂=CFOCF₂OCF₃, CF₂=CFOCF₂OCF₂CF₃, and CF₂=CFOCF₂OCF₂CF₂OCF₃.

It is preferable that the fluoromonomer represented by the general formula (140) be at least one selected from the group consisting of CF₂= CFOCF₂CF(CF₃)O(CF₂)₃F, CF₂=CFO (CF₂CF (CF₃)O)₂(CF₂)₃F, and CF₂=CFO(CF₂CF(CF₃)O)₂(CF₂)₂F.

It is preferable that the fluoromonomer represented by the general formula (150) be at least one selected from the group consisting of CF₂=CFOCF₂CF₂SO₂F, CF₂=CFOCF₂CF (CF₃) OCF₂CF₂SO₂F, CF₂=CFOCF₂CF(CF₂CF₂SO₂F)OCF₂CF₂SO₂F, and CF₂=CFOCF₂CF(SO₂F)₂.

In the present specification, the "organic group" means a group having one or more carbon atoms or a group formed by removing one hydrogen atom from an organic compound.

Examples of the "organic group" include:
an alkyl group which may have one or more substituents,
an alkenyl group which may have one or more substituents,
an alkynyl group which may have one or more substituents,
a cycloalkyl group which may have one or more substituents,
a cycloalkenyl group which may have one or more substituents,
a cycloalkadienyl group which may have one or more substituents,
an aryl group which may have one or more substituents,
an aralkyl group which may have one or more substituents,
a non-aromatic heterocyclic group which may have one or more substituents,
a heteroaryl group which may have one or more substituents,
a cyano group, a formyl group, RaO-, RaCO-, RaSO₂-, RaCOO-, RaNRaCO-, RaCONRa-, RaOCO-, RaOSO₂-, and RaNRbSO₂-,
wherein Ra is independently
an alkyl group which may have one or more substituents,
an alkenyl group which may have one or more substituents,
an alkynyl group which may have one or more substituents,
a cycloalkyl group which may have one or more substituents,
a cycloalkenyl group which may have one or more substituents,
a cycloalkadienyl group which may have one or more substituents,
an aryl group which may have one or more substituents,
an aralkyl group which may have one or more substituents,
a non-aromatic heterocyclic group which may have one or more substituents, or
a heteroaryl groups which may have one or more substituents, and
Rb is independently an alkyl group which may have H or one or more substituents.

It is preferable that the organic group be an alkyl group which may have one or more substituents.

As the fluororesin particles (A), FEP, PFA or EPA is preferred in terms of non-stickiness and surface smoothness, and PFA, which has a melting point of 300°C or more, is particularly preferred due to no occurrence of deformation during soldering.

The fluororesin particles (A) have an average particle size of 0.05 to 1000 µm, preferably 0.1 to 100 µm, and more preferably 0.1 to 30 µm. An average particle size within the range is preferred, because a smooth coating resin layer made of thin film can be obtained.

The average particle size is a volume average particle size measured by, for example, a laser diffraction/scattering method. In order to make the fluororesin particles (A) have a desired particle size, classification may be performed by sieving or wind power.

The fluororesin particles (A) have a particle size at a cumulative volume of 50% of 0.05 to 40 µm, and more preferably 7 to 40 µm. The particle size at a cumulative volume of 50% is a particle size determined as follows. The particle size distribution is measured by the laser diffraction/scattering method to obtain a cumulative curve relative to the total volume of particle population as 100%. The particle size at a cumulative volume of 50% corresponds to a point where the cumulative volume reaches 50% on the cumulative curve. A particle size at a cumulative volume of 50% within the range is preferred, because a smooth coating resin layer made of thin film can be formed.

The method for producing the fluororesin particles (A) described above is not limited, and specifically, the fluororesin particles (A) can be produced by, for example, the method described in Japanese Patent Laid-Open No. 2009-1767.

The polymerization method of the fluororesin constituting the fluororesin particles (A) is not limited, and examples thereof include bulk polymerization, suspension polymerization, solution polymerization, and emulsion polymerization. In the polymerization, each of the conditions such as temperature and pressure, the polymerization initiator and other additives may be appropriately set according to the desired compositional features and amount of the fluororesin.

The blending amount of the fluororesin particles (A) in the aqueous coating material composition relative to the total mass of the composition is 15 to 80 mass%, preferably 15 to 75 mass%, and more preferably 20 to 50 mass%. With a blending amount of the fluororesin particles (A) of less than the lower limit, the viscosity is too low, so that application to an article surface immediately causes dripping and thick coating cannot be achieved. On the other hand, with a too large blending amount of the fluororesin particles (A), the coating material composition has no flowability, so that coating cannot be achieved. The specific blending amount may be appropriately selected within the range in consideration of the coating method, adjustment of the film thickness, etc., and it is preferable that in the case of spray coating, etc., the concentration be set to a relatively low level, while in the case of coating with pressure, etc., the concentration be set to 50 mass% or more to make a paste form.

In the present disclosure, the solid content concentration of the aqueous coating material composition is measured by a heating residue mass measuring method.

The aqueous coating material composition of the present disclosure has a mass ratio: Fluororesin particles (A)/Silica particles (B) = 10/90 to 90/10. By blending the fluororesin particles (A) and the silica particles (B) at the ratio, the effect of preventing warpage and the like can be obtained. Regarding the blending amount, the lower limit of the blending amount of the fluororesin particles (A) is more preferably 10 and still more preferably 20. Regarding the blending amount, the upper limit of the blending amount of the fluororesin particles (A) is more preferably 90, and still more preferably 80. Regarding the blending amount, the upper limit of the blending amount of the silica particles (B) is more preferably 60, and still more preferably 50.

The aqueous coating material composition of the present disclosure further contains a non-fluorinated surfactant (C). Considering the cost, to contain a non-fluorinated surfactant instead of a fluorinated surfactant is one of the reasons why the aqueous coating material composition of the present disclosure is preferred.

Further, in the case where a fluorinated surfactant is blended, hydrofluoric acid is generated in sintering of the fluororesin particles (A). Since the hydrofluoric acid accelerates the deterioration of the silica particles (B), containing no fluorinated surfactant is preferred.

The non-fluorinated surfactant (C) is not limited as long as the fluororesin particles (A) can be stably dispersed in the composition, and any one of anionic surfactants, cationic surfactants, nonionic surfactants and amphoteric surfactants may be used. Examples thereof include anionic surfactants such as sodium alkyl sulphate, sodium alkyl ether sulphate, triethanolamine alkyl sulphate, triethanolamine alkyl ether sulphate, ammonium alkyl sulphate, ammonium alkyl ether sulphate, alkyl ether sodium phosphate, and sodium fluoroalkyl carboxylate; cationic surfactants such as alkylammonium salts and alkylbenzylammonium salts; nonionic surfactants such as polyoxyethylene alkyl ethers, polyoxyethylene phenyl ethers, polyoxyethylene alkyl esters, propylene glycol-propylene oxide copolymers, perfluoroalkylethylene oxide adducts, 2-ethylhexanol ethylene oxide adducts; and amphoteric surfactants such as alkylamino acetate betaine, alkylamide acetate betaine, and imidazolium betaine. Among these, anionic and nonionic surfactants are preferred. Particularly preferable surfactants are nonionic surfactants with an oxyethylene chain having less amount of pyrolysis residual quantity.

As the non-fluorinated surfactant (C), acetylene surfactants such as hydrocarbon surfactants, silicone surfactants, and acetylene glycol may be also used. Further, among these non-fluorinated surfactants, one or a combination of two or more may be used. Incidentally, it is preferable not to use nonylphenol surfactants.

As the non-fluorinated surfactant (C), silicone surfactants are particularly preferred. The silicone surfactants are not limited, and examples thereof include an organopolysiloxane modified with a hydrophilic group such as polyoxyethylene (POE)-modified organopolysiloxane, polyoxyethylene/polyoxypropylene (POE/POP)-modified organopolysiloxane, POE sorbitan-modified organopolysiloxane, and POE glyceryl-modified organopolysiloxane.

Specific examples thereof include DBE-712 and DBE-821 (manufactured by Azmax Corp.), KP series, KF-6015, KF-6016, KF-6017 and KF-6028 (manufactured by Shin-Etsu Chemical Co., Ltd.), ABIL-EM97 (manufactured by Goldschmidt-Thermit Japan Co., Ltd.), Polyflow KL-100, Polyflow KL-401, Polyflow KL-402, and Polyflow KL-700 (manufactured by Kyoeisha Chemical Co., Ltd.), "FZ-77" (manufactured by Toray Dow Corning Co., Ltd.), and "BYK-333" (manufactured by Big Chemie Japan KK).

The blending amount of the non-fluorinated surfactant (C) relative to 100 mass% of the fluororesin particles (A) is preferably 0.01 to 50 mass%, more preferably 0.1 to 30 mass%, and more preferably 0.2 to 20 mass%. With a too small amount of the surfactant added, the fluororesin particles may not be uniformly dispersed and may partially float. On the other hand, with a too large amount of the surfactant added, the decomposition residue of the surfactant resulting from sintering increases to cause coloring, and the heat resistance and non-stickiness of the coating film deteriorate.

The aqueous coating material composition of the present disclosure contains water (D) as solvent. The medium of water is preferred in terms of little adverse effect on the environment.

Further, it is preferable that the aqueous coating material composition of the present disclosure contains a water-soluble solvent in combination with water. The water-soluble solvent has a function of wetting the fluororesin particles (A), and the solvent having a high boiling point acts as a drying retarder that connects the resins to each other during drying after coating to prevent the occurrence of cracks. Even a high boiling point solvent evaporates at the sintering temperature of the fluororesin, having no negative effect on the coating film.

Specific examples of the water-soluble solvent include a low boiling point organic solvent having a boiling point of up to 100°C such as methanol, ethanol, isopropanol, sec-butanol, t-butanol, acetone, and methyl ethyl ketone; a medium boiling point organic solvent having a boiling point of 100 to 150°C such as methyl cellosolve and ethyl cellosolve; a high boiling point organic solvent having a boiling point of 150°C or more such as N-methyl-2-pyrrolidone, N,N-dimethylacetamide, 3-butoxy-N,N-dimethylpropanamide, 3- butoxy-N,N-dimethylpropanamide, N,N-dimethylformamide, ethylene glycol, propylene glycol, glycerol, dimethyl carbitol, butyl dicarbitol, butylcellosolve, 1,4-butanediol, diethylene glycol, triethylene glycol, and tetraethylene glycol. One of the water-soluble solvents or a mixture of two or more may be used. As the water-soluble solvent, a high boiling point organic solvent is preferred, and in particular, the glycol solvent (E) is more preferred in terms of dispersion stability and safety.

The blending amount of the water-soluble solvent is preferably 0.5 to 50 mass%, more preferably 1 to 30 mass%, relative to the total amount of water. In the case of a low boiling point organic solvent, with a too small blending amount, bubbles are likely to be embraced, while with a too large blending amount, the entire composition becomes flammable and the advantage of the aqueous dispersion composition is impaired. In the case of a medium boiling point organic solvent, with a too large blending amount, the solvent may remain in the coating film even after sintering to have a negative effect, while with a too small blending amount, the fluororesin returns to powder during drying after coating and cannot be sintered. In the case of a high boiling point organic solvent, with a too large blending amount, the solvent may remain in the coating film even after sintering to have a negative effect. It is preferable that none of the water-soluble solvent remain in the coating film after sintering of the fluororesin particles (A) through selection of the solvent having volatile property or adjustment of the blending amount. Absence of the glycol solvent (E) remaining after sintering of the fluororesin particles (A) can be confirmed by no weight loss of the coating film scraped off after sintering near the boiling point of the glycol solvent in the TG/DTA measurement.

The aqueous coating material composition of the present disclosure may further contain a binder resin on an as needed basis. However, in this case, it is preferable not to contain a resin having a weight loss of less than 55% at 400°C measured under conditions at 10°C/min under N₂. In an aqueous coating material composition containing such a resin, the binder resin may remain without being completely decomposed even after heating for forming a coating film, so that the physical properties of the coating film may deteriorate.

The aqueous coating material composition contains various additives usually added to a fluororesin composition, for example, pigments, stabilizers, thickeners, decomposition accelerators, rust inhibitors, preservatives, and antifoaming agents. Examples of the pigments include inorganic pigments and composite oxide pigments such as white carbon, calcium carbonate, barium sulfate, talc and calcium silicate.

The aqueous coating material composition may be a clear coating material containing no coloring pigment, or may be a coloring coating material containing a coloring pigment on an as needed basis.

The present disclosure also relates to a coated article characterized by having a coating layer formed by coating the aqueous coating material composition.

The aqueous coating material composition may be applied by a coating method used for ordinary coating material, and examples of the coating method include spray coating, roll coating, coating with a doctor blade, dip (immersion) coating, impregnation coating, spin flow coating, curtain flow coating, coating with a bar coater, gravure coating, and micro gravure coating.

After the coating, the coated article of the present disclosure can be obtained through drying and sintering. The drying is not limited as long as the aqueous medium can be removed, and examples thereof include a method of heating at room temperature to 130°C for 5 to 30 minutes on an as needed basis. The sintering is performed at a temperature equal to or more than the melting temperature of the fluororesin particles, and is usually performed preferably in the range of 200 to 400°C for 10 to 60 minutes. In order to prevent oxidation of the coated metal foil, it is preferable that drying and sintering be performed under an inert gas.

Examples of the usable article substrate of the coated article of the present disclosure include metals such as iron, stainless steel, copper, aluminum and brass; glass products such as glass sheets, woven fabrics of glass fiber and nonwoven fabrics of glass fiber; articles molded of or covered with a general-purpose or heat-resistant resin such as polypropylene, polyoxymethylene, polyimide, modified polyimide, polyamideimide, polysulfone, polyether sulfone, polyether ether ketone, and liquid crystal polymer; articles molded of or covered with a general-purpose elastomer such as SBR, butyl elastomer, NBR, and EPDM, or heat-resistant elastomer such as silicone elastomer and fluoroelastomer; woven fabrics and non-woven fabrics of natural fiber or synthetic fiber; or laminated substrates formed of combination thereof.

The article substrate may be surface-treated. Examples of the surface treatment include surface roughening to a desired roughness by sandblasting, surface roughening by adhering particles, and processing to prevent metal oxidation.

The coated article of the present disclosure is usable in a field requiring heat resistance, solvent resistance, lubricity, or non-stickiness, and may be used for films, fiber-reinforced films, prepregs, metal foils with resin, metal-clad laminates, printed circuit boards, dielectric materials for circuit boards, laminated circuit boards, etc.

It is particularly preferred that the coated article of the present disclosure has a coating layer formed of the aqueous coating material composition of the present disclosure on a copper foil. In recent years, communication in high frequency regions has become popular in various fields. In order to reduce the transmission loss for use in high frequency regions, a laminate of a dielectric layer containing a fluoropolymer and a copper foil is used. In such applications, the aqueous coating material composition of the present disclosure can be particularly suitably used.

### Examples

The present disclosure is described with reference to Examples as follows. In Examples, % and parts as units used for the blending ratio mean mass% and parts by mass, respectively, unless otherwise specified. The present disclosure is not limited to Examples described below.

### Example 1

### Step 1: Preliminary crushing (dry crushing)

A tetrafluoroethylene (TFE)/perfluorovinyl ether (PFVE) copolymer (PFA: melting point=300°C, MFR=25 g/10 min) was produced by suspension polymerization, and the resulting dry powder was directly crushed with an air jet mill (manufactured by I.M. Material Corporation) to make a fine powder having an average particle size of 10 µm.

### Step 2: Preliminary mixing (preliminary dispersion)

With 10 parts by mass of acetylene glycol dispersant (Surfynol 440, manufactured by Air Products and Chemicals, Inc.), 10 parts by mass of silicone surfactant (KP-106, manufactured by Shin-Etsu Chemical Co., Ltd.) and 280 parts by mass of ion-exchanged water, 100 parts by mass of the PFA fine powder obtained in the step 1 were sufficiently stirred and mixed, so that a PFA dispersion was obtained.

### Step 3: Wet crushing

The PFA dispersion obtained in step 2 was filtered with a 100-mesh wire screen, and then passed through a high-pressure emulsifier (Nanomizer NMII manufactured by Yoshida Kikai Industrial Co., Ltd., crushing pressure: 200 MPa) to obtain a dispersion of PFA fine powder having an average particle size of 0.20 µm (measured with CAPA700 manufactured by HORIBA, Ltd.) (fluororesin particle (A-1) dispersion).

The particle size at a cumulative volume of 50% of the resulting PFA fine powder was 0.20 µm.

### Step 4: Making of coating material

To 100 parts by mass of the PFA fine powder dispersion obtained by step 3, 2.5 parts by mass of a silicone surfactant (KP-106, manufactured by Shin-Etsu Chemical Industry Co., Ltd.), 2.5 parts by mass of ethylene glycol (manufactured by Futaba Chemical Co., Ltd.), 58 parts by mass of silica particles and further 20 parts by mass of ion-exchanged water were added to make a coating material.

The silica particles used were as follows.
B-1: Admafine SC2500-SQ manufactured by Admatechs, average particle size: 0.5 µm, specific surface area: 6.1 m²/g, maximum particle size: 1.7 µm
B-2: Admafine SC6500-SQ manufactured by Admatechs, average particle size: 1.5 µm, specific surface area: 4.0 m²/g, maximum particle size: 4.2 µm

It was confirmed that all of the silicas had good water dispersibility at 70 mass%.

### Examples 2 to 8

Making of coating material was performed in the same manner as in Example 1, except that each blending component was changed as shown in Table 1.

### Example 9

Making of coating material was performed in the same manner as in Example 1, except that a PFA fine powder having an average particle size of 25 µm was used, and wet crushing was omitted (fluororesin particles (A-2) dispersion).

The particle size at a cumulative volume of 50% of the resulting PFA fine powder was 22.9 µm.

### Examples 10 to 16

Making of coating material was performed in the same manner as in Example 9, except that each blending component was changed as shown in Table 2.

### Examples 17 to 20

Making of coating material was performed in the same manner as in Example 9, except that 10 parts by mass of 10 wt% aqueous solution of polyvinyl alcohol (PVA, saponification degree: 78 to 82 mol%, manufactured by Fuji Film Wako Pure Chemical Industries, Ltd.) was added as a binder resin and each blending component was changed as shown in Table 3.

### Comparative Examples 1 to 4

Making of coating material was performed in the same manner as in Examples 1 and 9, except that each blending component was changed as shown in Table 4.

As the fluorinated surfactant, 2.5 parts by mass of Ftergent 250 (manufactured by Neos Co., Ltd.) was added. In Comparative Example 4, making of coating material was performed without addition of ethylene glycol.

The resulting coating material composition was evaluated based on the following criteria.
A resin coating layer was obtained according to the following method.
A coating material was applied onto a copper foil (CF-V9S-SV-18 manufactured by Fukuda Metal Foil and Powder Co., Ltd.) with a bar coater (No. 40). The coated copper foil was dried at 130°C for 15 minutes to evaluate powder falling. Further, sintering was performed at 350°C for 15 minutes under a nitrogen gas atmosphere to prepare a coating film having a film thickness of 30 µm. No ethylene glycol remained in the coating film after sintering.

### (Warpage of copper-clad laminate)

The presence or absence of warpage of the resulting copper-clad laminate was visually checked.
Poor: Curled into a cylindrical shape.
Fair: Floating was observed.
Good: No floating was observed.

### (Powder falling)

When rubbed with a finger and when pressed with a finger, the falling out of fluororesin powder was visually checked.
Poor: Falling out was observed.
Good: No falling out was observed.

### (Deterioration of silica)

The coating surface was checked by SEM for presence or absence of deformation of silica particles.
Poor: Deformation was present.
Good: Deformation was absent.

**[Table 1]**

| | Example 1 | Example 2 | Example 3 | Example 4 | Example 5 | Example 6 | Example 7 | Example 8 |
|---|---|---|---|---|---|---|---|---|
| PFA particles | A-1 | A-1 | A-1 | A-1 | A-1 | A-1 | A-1 | A-1 |
| Type of silica | B-1 | B-1 | B-1 | B-1 | B-2 | B-2 | B-2 | B-2 |
| Type of surfactant | Silicone | | | | | | | |
| Binder | Absent | | | | | | | |
| PFA/Silica (wt%) | 30/70 | 40/60 | 50/50 | 60/40 | 30/70 | 40/60 | 50/50 | 60/40 |
| Warpage of copper foil | Fair | Good | Good | Good | Fair | Good | Good | Good |
| Powder falling | Good | Good | Good | Good | Good | Good | Good | Good |
| Deterioration of silica added | Good | Good | Good | Good | Good | Good | Good | Good |

**[Table 2]**

| | Example 9 | Example 10 | Example 11 | Example 12 | Example 13 | Example 14 | Example 15 | Example 16 |
|---|---|---|---|---|---|---|---|---|
| PFA particles | A-2 | A-2 | A-2 | A-2 | A-2 | A-2 | A-2 | A-2 |
| Type of silica | B-1 | B-1 | B-1 | B-1 | B-2 | B-2 | B-2 | B-2 |
| Type of surfactant | Silicone | | | | | | | |
| Binder | Absent | | | | | | | |
| PFA/Silica (wt%) | 30/70 | 40/60 | 50/50 | 60/40 | 30/70 | 40/60 | 50/50 | 60/40 |
| Warpage of copper foil | Fair | Good | Good | Good | Fair | Good | Good | Good |
| Powder falling | Good | Good | Good | Good | Good | Good | Good | Good |
| Deterioration of silica added | Good | Good | Good | Good | Good | Good | Good | Good |

**[Table 3]**

| | Example 17 | Example 18 | Example 19 | Example 20 |
|---|---|---|---|---|
| PFA particles | A-2 | A-2 | A-2 | A-2 |
| Type of silica | B-1 | B-1 | B-1 | B-1 |
| Type of surfactant | Silicone | | | |
| Binder | PVA | | | |
| PFA/Silica (wt%) | 30/70 | 40/60 | 50/50 | 60/40 |
| Warpage of copper foil | Good | Good | Good | Good |
| Powder falling | Excellent | Excellent | Excellent | Excellent |
| Deterioration of silica added | Good | Good | Good | Good |

**[Table 4]**

| | Comparative Example1 | Comparative Example2 | Comparative Example3 | Comparative Example4 |
|---|---|---|---|---|
| PFA particles | A-1 | A-2 | A-1 | A-1 |
| Type of silica | Absent | Absent | B-1 | Absent |
| Type of surfactant | Silicone | | Fluorinated | Silicone |
| PFA/Silica (wt%) | 100/0 | 100/0 | 40/60 | 100/0 |
| Warpage of copper foil | Poor | Poor | Good | Poor |
| Powder falling | Good | Good | Good | Poor |
| Deterioration of silica added | Good | Good | Poor | Good |

From the results in Tables 1 to 4, it has been shown that from the aqueous coating material composition of the present disclosure, an excellent fluororesin coating layer capable of suppressing warpage of a copper foil can be formed without occurrence of powder falling and deterioration of silica.

### Industrial Applicability

According to the present disclosure, an aqueous coating material composition capable of forming a coating layer excellent in suppression of powder falling and deterioration of silica particles, with suppressing warpage of a substrate such as a copper foil, can be obtained. The aqueous coating material composition is suitably used for coating of a printed circuit board, a dielectric material for a circuit board, a laminated circuit board, etc.

## Claims

1. An aqueous coating material composition comprising fluororesin particles (A) that can be melt-molded, further comprising silica particles (B), a non-fluorinated surfactant (C) and water (D),
wherein the fluororesin particles (A) have an average particle size of 0.05 to 1000 µm,
wherein the silica particles (B) have an average particle size of 0.1 to 20 µm,
wherein the fluororesin particles (A) and the silica particles (B) have a blending ratio: Fluororesin particles (A)/Silica particles (B) = 10/90 to 90/10 (mass ratio), and
wherein a content of fluororesin particles (A) is 15 to 80 mass% relative to 100 mass% of solid content of the coating material.

2. The aqueous coating material composition according to claim 1, further comprising a glycol solvent (E).

3. The aqueous coating material composition according to claim 2, wherein none of the glycol solvent (E) remain after sintering of the fluororesin particles (A).

4. The aqueous coating material composition according to any one of claims 1 to 3, wherein the silica particles (B) have a maximum particle size of 10 µm or less.

5. The aqueous coating material composition according to any one of claims 1 to 4, wherein the silica particles (B) have a water dispersibility of 30 mass% or more.

6. The aqueous coating material composition according to any one of claims 1 to 5, wherein the fluororesin particles (A) have an average particle size of 0.1 to 100 µm.

7. The aqueous coating material composition according to any one of claims 1 to 6, wherein the fluororesin particles (A) have a particle size at a cumulative volume of 50% of 0.05 to 40 µm.

8. The aqueous coating material composition according to any one of claims 1 to 7, wherein the non-fluorinated surfactant (C) is a silicone surfactant.

9. A coated article comprising a coating layer formed by application of the aqueous coating material composition according to any one of claims 1 to 8.

10. The coated article according to claim 9, wherein the coating layer is formed by application of the aqueous coating material composition according to any one of claims 1 to 8 on a metal substrate.

11. The coated article according to claim 9 or 10,
wherein the coated article is a printed circuit board, a dielectric material for a circuit board, or a laminated circuit board.
